Europäisches Patentamt

European Patent Office

Office européen des brevets

(11) Numéro de publication: **0 448 171 A1**

# DEMANDE DE BREVET EUROPEEN

(21) Numéro de dépôt: **91200605.3**

(51) Int. Cl.5: **H01L 31/167**

(22) Date de dépôt: **20.03.91**

(30) Priorité: **23.03.90 FR 9003735**

(43) Date de publication de la demande:
**25.09.91 Bulletin 91/39**

(84) Etats contractants désignés:
**DE FR GB**

(71) Demandeur: **PHILIPS COMPOSANTS**
**117, quai du Président Roosevelt**
**F-92130 Issy les Moulineaux(FR)**

(84) **FR**

Demandeur: **N.V. Philips'**
**Gloeilampenfabrieken**

**Groenewoudseweg 1**
**NL-5621 BA Eindhoven(NL)**

(84) **DE GB**

(72) Inventeur: **Thillays, Jacques**
**Société Civile S.P.I.D., 156, Boulevard**
**Haussmann**
**F-75008 Paris(FR)**

(74) Mandataire: **Jacquard, Philippe et al**
**Société Civile S.P.I.D. 156, Boulevard**
**Haussmann**
**F-75008 Paris(FR)**

(54) **Photocoupleur.**

(57) L'invention concerne un photocoupleur comprenant un élément photo-émetteur (9) et un élément photo-récepteur (10), l'élément photo-émetteur (9) présentant une première et une deuxième électrode en contact électrique avec respectivement une première (5) et une deuxième (6) broche de contact par rapport auxquelles l'élément photo-émetteur (9) est fixé en position, l'élément photo-récepteur (10) présentant une troisième et une quatrième électrode en contact électrique avec respectivement une troisième (7) et une quatrième broche (8) de contact par rapport auxquelles l'élément photo-récepteur (10) est fixé en position. L'élément photo-émetteur (9) et l'élément photo-récepteur (10) sont situés en regard l'un de l'autre et emprisonnés dans une première couche solide et transparente (15), entourée au moins en partie par une deuxième couche solide (16) agencée de manière à réfléchir la lumière. Selon l'invention, un boîtier pré-formé (1) comprend un fond (2) et des parois latérales (3), le fond (2) comportant au moins un logement (21) recevant une première extrémité des première (5), deuxième (6), troisième (7) et quatrième (8) broches et une première (31), deuxième (32), troisième (33) et quatrième (34) rainures dans lesquelles s'engagent une partie centrale (53, 63, 73, 83) de respectivement la première (5), deuxième (6), troisième (7) et quatrième (8) broche.

FIG.1a

La présente invention a pour objet un photo-coupleur comprenant un élément photo-émetteur et un élément photo-récepteur, l'élément photo-émetteur présentant une première et une deuxième électrode en contact électrique avec respectivement une première et une deuxième broche de contact par rapport auxquelles l'élément photo-récepteur est fixé en position, l'élément photo-récepteur présentant une troisième et une quatrième électrode en contact électrique avec respectivement une troisième et une quatrième broche de contact par rapport auxquelles l'élément photo-récepteur est fixé en position, l'élément photo-émetteur et l'élément photo-récepteur étant situés en regard l'un de l'autre et emprisonnés dans une première couche solide et transparente, entourée au moins en partie par une deuxième couche solide agencée de manière à réfléchir la lumière.

Un tel dispositif est connu de la demande de brevet français FR-2 262 407 déposée le 22 février 1974 par la Demanderesse. Dans celui-ci, la deuxième résine est rendue réfléchissante par le fait que son indice de réfraction est inférieur à celui de la première résine. Il est maintenant courant d'utiliser pour la deuxième couche, une résine chargée par exemple par du $TiO_2$ ("résine blanche"), laquelle possède intrinsèquement des propriétés réfléchissantes.

Les procédés de fabrication des photocoupleurs impliquent, en général, comme dernière étape, le moulage d'un boîtier opaque, puis sa polymérisation par cuisson.

L'invention a pour objet un photocoupleur mettant en oeuvre un boîtier pré-formé dans lequel sont disposés les éléments électriques et opto-électroniques le constituant ainsi que les résines.

La fabrication peut être ainsi rendue plus simple et plus rapide.

Dans ce but, un photocoupleur selon l'invention est caractérisé en ce qu'il comporte un boîtier pré-formé comprenant un fond et des parois latérales, le fond comportant au moins un logement recevant une première extrémité des premier, deuxième, troisième et quatrième broches, et une première deuxième, troisième et quatrième rainure, dans lesquelles s'engagent une partie centrale de respectivement la première, deuxième, troisième et quatrième broche.

Lors de l'assemblage, un peigne portant les broches, et sur lesquelles les éléments opto-électroniques sont solidarisés électriquement et mécaniquement est introduit dans les rainures au niveau de la partie centrale des broches jusqu'à ce que les extrémités des broches soient prises dans leur logement, assurant ainsi un positionnement mécanique précis des broches et des éléments photo-émetteur et photo-récepteur.

Selon un mode de réalisation avantageux, au moins une paroi interne jouxte la première extrémité d'au moins une broche, et de préférence elle est en contact mécanique au moins avec une portion de ladite première extrémité. On améliore ainsi la précision de positionnement des éléments photo-émetteur et/ou photo-récepteur.

Lesdites rainures peuvent être avantageusement disposées sur deux parois latérales opposées (pour des boîtiers du type à deux rangées dits "dual in line" ou DIL).

Un logement peut être prévu pour chaque broche.

Un logement comporte de préférence un chanfrein d'entrée.

Pour permettre l'implantation des broches dans un circuit imprimé, les broches peuvent être repliées, à l'extérieur du boîtier, parallèlement à la paroi latérale correspondante du boîtier.

L'invention concerne également un photocoupleur multiple comportant des photocoupleurs individuels alignés, tels que définis ci-dessus selon l'invention, et pourvus de moyens de séparation, de préférence constitués par un couplage à queue d'aronde.

L'invention sera mieux comprise à la lecture de la description qui va suivre, donnée à titre d'exemple limitatif, en liaison avec les dessins qui représentent :

- la figure 1a, une coupe longitudinale d'un photo-coupleur selon l'invention, la figure 1b étant un détail agrandi de la figure 1a, et la figure 1c une vue de dessous en coupe d'une variante de la figure 1a.
- la figure 2, une variante préférée du mode de réalisation des figures 1a à 1c.
- la figure 3, un photocoupleur multiple comportant des photo-coupleurs individuels tels que sur les figures 1 à 1c et/ou 2,
- et la figure 4 un photocoupleur individuel après séparation.

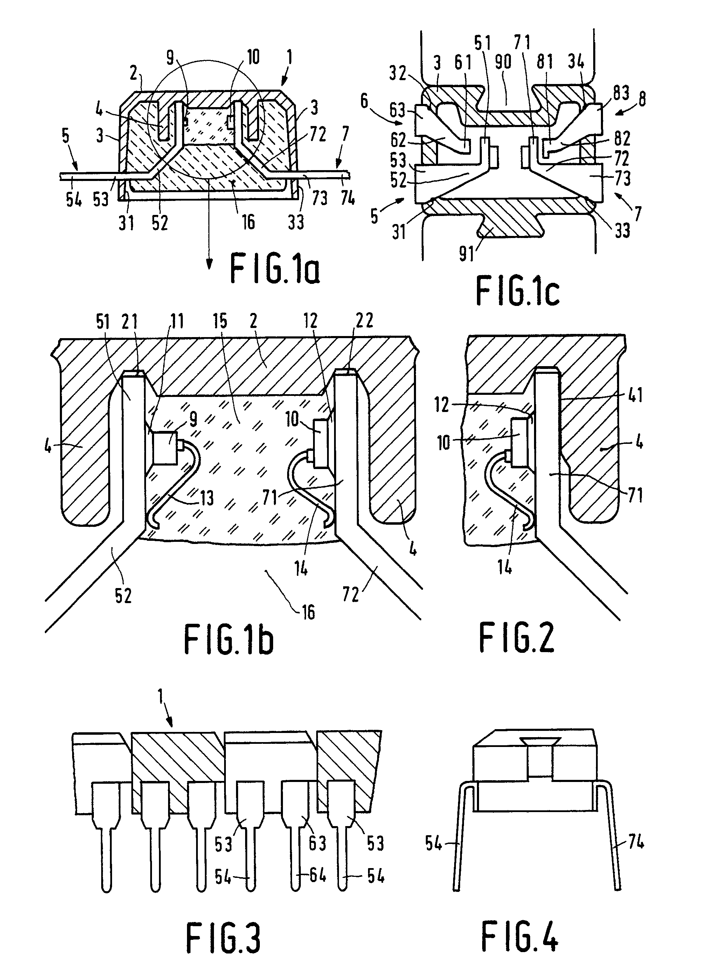

Selon la figure 1a, un photocoupleur comporte un boîtier désigné par le repère général 1 présentant un fond 2 et des parois latérales 3. Il s'agit d'un boîtier pré-formé s'apparentant à des boîtiers utilisés couramment par exemple pour des composants à deux rangées de broches ("DIL" ou "dual-in-line"). L'utilisation d'un tel boîtier permet d'utiliser un outillage standard pour disposer des broches 5 à 8 portées par des peignes et sur lesquelles ont été présentés des éléments opto-électroniques, à savoir un élément photo-récepteur 9 et un élément photo-émetteur 10. Plus particulièrement, l'élément 9 est soudé en 11 sur une extrémité 51 de la broche 5 de manière à connecter une première électrode de l'élément 9 à la broche 5 alors que son autre électrode est mise en contact avec une extrémité 61 de l'électrode 6 par un fil 13, par exemple soudé par thermo-compression. Il en va de même pour l'élément 10 (soudure en 12 sur l'extrémité 71 de la broche 7, fil 14 pour contact électrique avec l'extrémité 81 de la broche 8).

Le fond 2 du boîtier 1 présente un ou plusieurs logements (21, 22) (rainures, trou) de préférence chanfreinés, pour recevoir les extrémités 51, 61, 71 et 81 des broches 5 à 8 (ou certaines d'entre elles). L'extrémité (51, 61, 71, 81) des broches 5 à 8 se prolonge par une partie repliée à 45° (52, 62, 72, 82), puis par une partie centrale (53, 63, 73, 83) après un nouveau repliement à 45°, laquelle partie centrale s'engage dans une rainure (31, 32, 33, 34) ménagée à la partie inférieure (opposée au fond 2) de la paroi 3. Les rainures sont ici ménagées sur deux parois latérales opposées de la paroi 3 pour un montage DIL. La coopération des logements (21, 22) et des rainures (31, 32, 33, 34) permet un positionnement précis des broches avec un équipement d'implantation standard, et donc des éléments opto-électroniques (9, 10) l'un par rapport à l'autre, ceux-ci ayant été au préalable positionnés avec précision sur les bords 51 et 71.

Le fond 2 du boîtier étant disposé vers le bas, et préchauffé à 100°C, on coule une résine transparente 15 (par exemple la résine RTV141 de Rhône Poulenc) que l'on fait polymériser complètement (3 mm à 150°C pour la résine précitée).

Ensuite, sur le boîtier préchauffé à 100°C, on coule une résine réfléchissante 16 (ou d'indice inférieur à la première résine) dont la viscosité est de préférence élevée de manière à éviter tout écoulement par les rainures 31, 32, 33 et 34 au voisinage des portions centrales (53, 63, 73, 83) des broches 5 à 8. Une résine réfléchissante peut être par exemple composée de 100 parties pondérales d'ARALDITE F (CIBA-GEIGY), de 100 parties pondérales de durcisseur HY906 (CIBA-GEIGY), éventuellement de 0,3 parties pondérales d'un accélérateur DY064 (amine tertiaire), et enfin d'une charge consistant en 30 parties pondérales de $T_iO_2$. Pour améliorer l'adhérence avec le métal (cuivre) des broches, il est particulièrement avantageux d'ajouter un promoteur d'adhésion, par exemple 2 à 3 parties pondérales de l'agent de pontage silane A174 (Union Carbide) pour la résine transparente RTV 141 ou A187 pour la résine époxy (ARALDITE F). Le durcissement peut s'opérer à 150°C pendant 24 heures.

Ensuite on peut réaliser des opérations de découpage des peignes, de repliement éventuel des extrémités à souder (54, 64, 74, 84) en général moins large des broches 5 a 8 etc...

La figure 1b montre plus en détail le maintien des extrémités (51, 61, 71, 81) des broches. Une ou plusieurs parois internes 4 situées à proximité immédiate desdites extrémités permettent un meilleur positionnement. La ou les parois internes 4 peuvent présenter des bossages 41 qui sont en contact mécanique avec les extrémités (51, 61, 71, 81) ou certaines seulement d'entre celles-ci, pour guider plus précisément les broches.

En d'autres termes, les logements 21 et 22 assurant le positionnement en hauteur des broches, les rainures (31, 32, 33, 34) assurent le positionnement latéral des broches (la figure 1c représente un photocoupleur dépourvu de paroi 4). En outre, la présence éventuelle de la paroi 4 permet d'améliorer le parallélisme entre les extrémités 51 et 71 (ce sont essentiellement celles des broches (5, 7) qui portent les éléments 9 et 10 qui sont concernés) et les bossages 41 optimisent ce parallélisme.

Selon les figures 3 et 4, les photocoupleurs individuels peuvent être disposés en rangée, les boîtiers 1 étant pourvus à cet effet de moyens de couplage tels que des queues d'aronde (partie femelle 90 et partie mâle 91 aux figures 1c et 4). On remarquera que la fabrication des photocoupleurs peut être réalisée en assemblant préalablement en ligne les boîtiers 1 vides, le montage des broches se faisant facilement à partir de peignes à pas standard, les photocoupleur étant ensuite utilisés individuellement, ou collectivement en nombre voulu, en tant que de besoin.

On remarquera qu'à la figure 3, les broches ont été repliées, à l'extérieur du boîtier 1, de telle sorte que leurs extrémités (54 etc...) amincies puissent être soudées à travers les trous d'un circuit imprimé.

## Revendications

1. Photocoupleur comprenant un élément photoémetteur et un élément photo-récepteur, l'élément photo-émetteur pré-sentant une première et une deuxième électrode en contact électrique avec respectivement une première et une deuxième broche de contact par rapport auxquelles l'élément photo-émetteur est fixé en position, l'élément photo-récepteur présentant une troisième et une quatrième électrode en contact électrique avec respectivement une troisième et une quatrième broche de contact par rapport auxquelles l'élément photo-récepteur est fixé en position, l'élément photo-émetteur et l'élément photo-récepteur étant situés en regard l'un de l'autre et emprisonnés dans une première couche solide et transparente, entourée au moins en partie par une deuxième couche solide agencée de manière à réfléchir la lumière caractérisé en ce qu'il comporte un boîtier pré-formé (1) comprenant un fond (2) et des parois latérales (3), le fond comportant au moins un logement (21, 22) recevant une première extrémité (51, 61, 71, 81) des première (5), deuxième (6), troisième (7) et quatrième (8) broches et une première (31), deuxième (32), troisième (33) et quatrième (34) rainures dans lesquelles s'engagent une partie centrale de respectivement la première (5), deuxième (6), troisième (7) et quatrième broche (8).

2. Photocoupleur selon la revendication 1, caractérisé en ce qu'il comporte au moins une paroi interne (4) jouxtant la première extrémité d'au moins une broche (5, 6, 7, 8).

3. Photocoupleur selon la revendication 2, caractérisé en ce que ladite paroi interne (4) est en contact mécanique (41) au moins avec une portion de ladite première extrémité (51, 61, 71, 81).

4. Photocoupleur selon une des revendications précédentes caractérisé en ce que lesdites rainures (21, 22) sont disposées sur deux parois latérales opposées.

5. Photocoupleur selon une des revendications précédentes caractérisé en ce qu'il comporte un logement (21,22) pour chaque broche.

6. Photocoupleur selon la revendication 5 caractérisé en ce que ledit logement (21, 22) présente un chanfrein d'entrée.

7. Photocoupleur selon une des revendications précédentes caractérisé en ce qu'à l'extérieur du boîtier, les broches sont repliées parallèlement à la paroi latérale correspondante (3) du boîtier (1) de manière qu'une deuxième extrémité (54, 64, 74, 84) de celles-ci, opposée à ladite première extrémité (51, 61, 71, 81) soit implantable à travers des trous d'un circuit imprimé.

8. Photocoupleur selon une des revendications précédentes caractérisé en ce que la deuxième couche solide (16) est réfléchissante.

9. Photocoupleur selon une des revendications précédentes caractérisé en ce que la deuxième couche solide (16) est transparente et a un indice de réfraction inférieur à celui de la première couche solide (15).

10. Photocoupleur multiple comportant des photocoupleurs individuels alignés caractérisé en ce qu'ils sont selon une des revendications précédentes et sont pourvus de moyens de séparation.

11. Photocoupleur selon la revendication 10, caractérisé en ce que lesdits moyens de séparation sont constitués par un couplage à queue d'aronde (90, 91).

FIG.1a

FIG.1c

FIG.1b

FIG.2

FIG.3

FIG.4

## Office européen
## des brevets

# RAPPORT DE RECHERCHE
# EUROPEENNE

Numéro de la demande

# EP 91 20 0605

# DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | EP-A-0 103 032 (GENERAL ELECTRIC COMPANY) * page 14, ligne 24 - page 15, ligne 17; revendications ; figures 8, 9 * | 1,7,10 | H 01 L 31/167 |
| A,D | FR-A-2 262 407 (RTC LA RADIOTECHNIQUE COMPE-LEC) * revendications ; figures * | 1,7 | |
| A | US-A-4 047 045 (G.W.PAXTON, JR ET AL.) * le document en entier * | 1,7 | |
| A | PATENT ABSTRACTS OF JAPAN vol. 8, no. 200 (E-266)(1637) 13 septembre 1984, & JP-A-59 87880 (TOSHIBA K.K.) 21 mai 1984, * le document en entier * | 1,7 | |

| DOMAINES TECHNIQUES RECHERCHES (Int. Cl.5) |
|---|
| H 01 L |

Le présent rapport de recherche a été établi pour toutes les revendications

| Lieu de la recherche | Date d'achèvement de la recherche | Examinateur |
|---|---|---|
| La Haye | 20 juin 91 | LINA F. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire
T : théorie ou principe à la base de l'invention

E : document de brevet antérieur, mais publié à la date de dépôt ou après cette date
D : cité dans la demande
L : cité pour d'autres raisons

& : membre de la même famille, document correspondant